# EUROPEAN PATENT SPECIFICATION

(11) **EP 1 789 846 B1**
(45) Date of publication and mention of the grant of the patent: **24.02.2010**
(21) Application number: 05744373.1
(22) Date of filing: 23.05.2005
(51) Int. Cl.: G03F 7/00, G03F 7/20

(54) **FABRICATION OF POLYMERIC STRUCTURES**
HERSTELLUNG VON POLYMERSTRUKTUREN
FABRICATION DE STRUCTURES POLYMERES

(30) Priority: 21.05.2004 GB 0411348
(43) Date of publication of application: 30.05.2007
(73) Proprietor: CRANFIELD UNIVERSITY, Milton Keynes, Bedfordshire MK45 4DT (GB)
(72) Inventor: PILETSKY, Sergey, Anatoliyovich, Cranfield Bedfordshire MK43 0EE (GB); CULLEN, David Charles, Cambridge, Cambridgeshire CB4 1TY (GB); HENRY, Olivier, Yves, Frederic, F-29900 Concarneau (FR)
(74) Representative: Stuart, Ian Alexander
(86) International application number: PCT/GB2005/002024
(87) International publication number: WO 2005/114329

(56) References cited:
- WO-A-88/06494
- WO-A-2004/006840
- US-B1- 6 214 276
- SCARPARO M A F ET AL: "New infrared stereolithography: control of the parameters of the localized curing thermosensitive materials" PROCEEDINGS OF THE SPIE - THE INTERNATIONAL SOCIETY FOR OPTICAL ENGINEERING SPIE-INT. SOC. OPT. ENG USA, vol. 3933, 2000, pages 396-403, XP002377794 ISSN: 0277-786X

## Description

### Technical Field

Broadly the present invention describes the fabrication of spatially controlled polymeric structures using a radiation or particle beam. The resulting structures find use in a variety of electrophoretic and sensor applications, including clinical assays, high throughput screening for genomics, proteomics and pharmaceutical applications, point-of-care *in vitro* diagnostics, molecular genetic analysis and nucleic acid diagnostics, cell separations, and bioresearch generally, high throughput screening of materials for separation and catalysis.

### Background Art

| Patent | Country | Issued | Title |
|---|---|---|---|
| 6,656,668 | USA | December 2, 2003 | Process method of using excimer laser for forming micro spherical and non-spherical polymeric structure array |
| 6,480,324 | USA | November 12, 2002 | Methods involving direct write optical lithography |
| 0028804A1 | USA | February 12, 2004 | Production of polymeric microarrays |
| 6,544,698 | USA | April 8, 2003 | Maskless 2-D and 3-D pattern generation photolithography |
| US2003186140 | USA | February 10, 2003 | Maskless photolithography for using photoreactive agents |
| EP1331516 | USA | July 30, 2003 | Method and mask for fabricating features in a polymer layer |

Microarray fabrication technology has been developed recently, based on the deposition of a discrete amount of materials using a robotic handling device. In this approach an array of liquid pre-polymerisation mixture comprising of liquid monomer that may be combined with other monomer(s), solvent, initiator, chemical and biochemical compound(s), dissolved polymer is first deposited on a substrate and then polymerised *in situ* by presenting the array to initiating conditions. This approach suffers from the difficulty of maintaining integrity of the materials deposited before exposure to initiating conditions, which has large consequences on the quality of the resulting polymeric structures. Evaporation, effect of presence of oxygen, surface properties of the substrate, quantity that can be deposited and shapes of structures that can be fabricated all affect the quality and quantity of deposited material making it very difficult to control.

Polymer arrays can be formed using photomasks (EP1331516). This method is similar to manufacturing integrated circuits. Light is applied through a mask that has a predefined image pattern which leads to initiation at polymerisation in certain regions of a substrate but not in others. The substrate can include solids, such as silicon, glass, quartz, and polymers. The fabrication of a multicomponent array in general requires the use of multiple varieties of masks, which is not always convenient. In addition this approach suffers from the limitations highlighted above.

According to another approach, direct optical photolithography can be performed with an optical beam without the use of photomasks (USA 6,480,324). The light patterns are generated by a spatial light modulator controlled by a computer, rather than being defined by a pattern on a photomask. Here each pixel is illuminated with an optical beam of suitable intensity and the imaging (printing) of an individual feature on a substrate is determined dynamically by computer control. This invention employs a programmable micro-mirror array, which plays an essentially similar role to photomask. It is centered around the development of nucleic acid arrays and also involves photochemistry. Many of the compounds that are potentially useful for manufacturing polymer arrays are photosensitive and can decompose upon illumination.

Document US 6 214 276 discloses a method for fabricating a pattern of polymeric material on a substrate wherein a radiation bean is absorbed directly within the liquid polymerisable solution to initiate polymerisation.

### Disclosure of Invention

A preferred embodiment of the invention can provide a fabrication method that avoids or reduces the limitations mentioned above in order to produce patterned polymeric structures. Thus the invention provides a method of fabricating a structure or pattern comprising a polymeric material on a substrate, comprising (a) providing a substrate; (b) providing a liquid phase comprising a polymerisable material in contact with a surface of said substrate; (c) directing a radiation beam to impinge on said surface at the substrate/liquid phase interface so as to cause localised heating of the substrate and thereby to initiate polymerisation adjacent the irradiated site; and (d) causing the beam to scan in a predetermined pattern, thereby initiating polymerisation in a corresponding pattern. NB The reference to causing the beam to "scan" means that it is caused to move across the surface in a controlled way corresponding to a desired pattern which can be continuous or discontinuous (or both in different regions).

The beam is preferably a laser beam, especially an IR laser beam.

Spatially controlled polymeric structures are fabricated by using a laser beam, preferably an IR heat generating CO₂ laser, which initiates polymerisation on the pre-determined areas of surface. The polymer structures are created on a substrate surface by directing the laser beam according to a pre-determined pattern. Accordingly the invention provides a means to grow, rather than deposit, polymers of desired shapes from a pre-polymerisation mixture in the liquid phase on a substrate as predetermined by a user. The subject devices find use in a variety of electrophoretic and sensor applications, including clinical assays, high throughput screening for genomics, proteomics and pharmaceutical applications, point-of-care *in vitro* diagnostics, molecular genetic analysis and nucleic acid diagnostics, cell separations, and bioresearch generally, high throughput screening of materials for separation and catalysis.

A preferred embodiment of the invention will now be described with reference to the accompanying drawings.

### Brief Description of Drawings

FIGURE 1 shows a schematic of the embodiment of the invention
FIGURE 2 shows an alternative embodiment of the invention
FIGURE 3 is a photograph of an array of 25 polymer dots produced according to an embodiment of the invention as shown in Figure 1
FIGURE 4 is a photograph of a single dot

### Modes for Carrying Out the Invention

The first embodiment of the present invention describes performing of the polymer deposition using IR laser with electromechanical laser galvanometer scanning system. The set-up consists of a reservoir 2 containing a solution 3 comprising a mixture of monomer(s) with initiator dissolved in an appropriate solvent. The monomer mixture is in contact with a thin sheet 1 of a substrate. Typically the substrate covers the reservoir, and a laser beam 4 is applied from above (4).

The laser beam is generated by a CO₂ infrared laser 10 and passes to a movable mirror 12, moved by a motor 14 controlled by a computer 16. The diagram is highly schematic; in practice we used a commercial product, a FENIX laser marker (SYNRAD, Inc, Wisconsin, USA), with a 30W CO₂ laser and an X-scanning mirror. Laser beam 4 is directed to pass through the substrate (1) following a user-designed pattern. It heats locally zones of the substrate. The initiator in close proximity to these zones at the lower surface of the substrate decomposes, initiating polymerisation. The growth of polymer structures 5 is dependent on factors such as beam intensity, time of exposure, and properties of the substrate and its surface.

In some embodiments of the present invention the properties of the substrate and/or the wavelength and/or intensity of the laser beam are adapted using methods well established in the art, to allow higher control over the polymer adhesion, morphology and polymerisation time. Thus the surface of the substrate can be optionally modified with polymerisable compound or with immobilised initiator molecules to promote polymer growth and adhesion.

In some embodiments, initiator is not present in the solution and is used only in immobilised form.

The pre-polymerisation mixture may contain one or several monomers and be combined with solvents, polymerisation initiators, dissolved polymers, natural or synthetic biochemical and chemical compounds.

A reservoir for holding the mixture can be made of silicon, glass, metal, plastic, ceramic or a combination of these. The cavity containing pre-polymerisation mixture may be emptied and re-filled with pre-polymerisation mixture of varying compositions to allow for the fabrication of an array of structures of varying nature, composition and properties.

In other embodiments of the invention the energy will be applied to initiate polymerisation in different ways, including using light (e.g. an excimer laser), focused ionic, particle, X-ray and electron beams. The pattern can be changed by re-focusing and re-directing the applied energy.

In some embodiments of the invention, the monomer mixture contains template molecules which will be extracted from the formed polymer structures creating imprinted cavities capable of selective recognition, signalling or catalysis. Development of these materials (molecularly imprinted polymers) is a well established process. Depending on the application, functional monomer(s) and/or template can contain fluorescent tags (reporters) which will allow detection of target compounds. The application of fluorescent tags and environmental sensitive probes is well known in the art.

The invention is also concerned with the application of the fabricated spatially controlled polymeric structures. These devices may be used in a variety of applications, including, e.g., high throughput screening assays in drug discovery, immunoassays, diagnostics, genetic analysis, and the like. In another aspect the structures (arrays) will be used as sensor components, lab-on-a-chip for performing chemical and / or biological experiments and as research platform for studying and optimising separation, molecular recognition and catalytic processes.

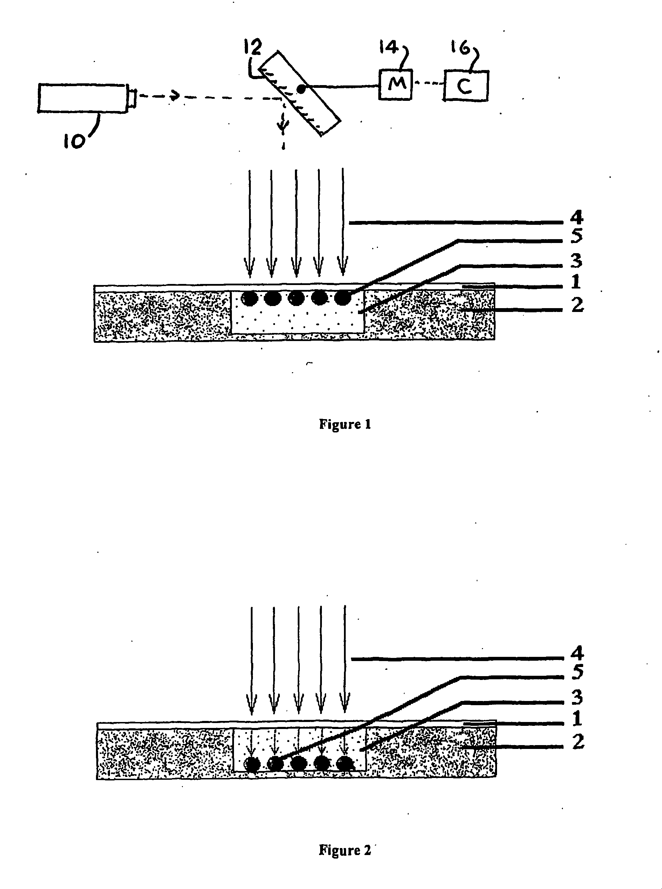

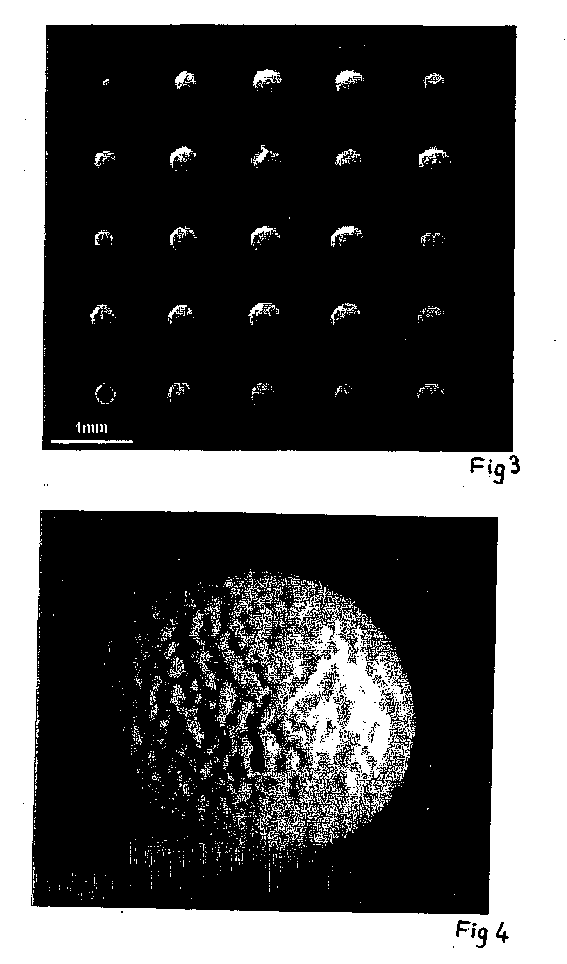

The present invention will now be further particularly described with reference to the following, non-limiting examples.
1. **Development of "top" polymer array**. This used apparatus as shown in Fig. 1. The pre-polymerisation mixture consisted of the monomers methacrylic acid (MAA) and 2-vinylpyridine (2-VyP), the cross-linker ethylene glycol dimethacrylate (EGDMA), the porogen poly(vinyl acetate) (PVA), and the initiator azobisisobutyronitrile (AIBN), all dissolved in acetonitrile. The substrate (1) was a microscope cover slip made of borosilicate glass. The laser employed was a CO₂ infrared LASER (λ=1066nm) and was programmed to scan repeatedly 25. dots as laser pulses, organised in an array of 5 by 5 dots. In this particular example local heat was generated at the surface of substrate (1) as borosilicate is non-transparent to infrared light. Heat pulses generated locally during each laser pulse initiated the polymerisation process and produced dots such as the ones depicted in Figure 3. The enlarged image of a single dot is presented in Figure 4.
2. **Development of "bottom" polymer array**. This used apparatus as shown in Fig. 2. The pre-polymerisation mixture was the same as in Example 1. The apparatus was largely the same, except that the cover layer 21 was of a material substantially transparent to the laser radiation, in this case a 3 mm thick silver halide (AgClₓBr₁₋ₓ) glass. As before, the laser was programmed to scan repeatedly 25 dots as laser pulses, organised in an array of 5 by 5 dots. In this example, local heat was generated at the bottom of the reservoir, in a substrate layer 22. Thus the polymer pattern was generated there.
   Materials for use as cover layers and/or bottom substrates include glass, plastic, metal, ceramic, quartz, ceramic, silver halide (AgClₓBr₁₋ₓ and combinations of these. If the invention is to produce an array on a bottom layer, then plainly the cover layer must be at least partly transparent to the radiation. It may still heat up significantly if use is made of initiator coated on the bottom layer instead of being in solution. Of course the "bottom substrate" does not need to be the bottom of the reservoir, but could be an element of sheet material placed in the reservoir.

## Claims

1. A method of fabricating a structure or pattern comprising a polymeric material on a substrate, comprising (a) providing a substrate; (b) providing a liquid phase comprising a polymerisable material in contact with a surface of said substrate; (c) directing a radiation beam to impinge on said surface at the substrate/liquid phase interface so as to cause localised heating of the substrate and thereby to initiate polymerisation adjacent the irradiated site; and (d) causing the beam to scan in a predetermined pattern, thereby initiating polymerisation in a corresponding pattern.

2. A method according to claim 1 wherein said beam is a beam of visible light, IR, UV, X-rays, ions, particles or electrons.

3. A method according to claim 2 wherein the beam is a laser beam.

4. A method according to any preceding claim wherein the beam is IR.

5. A method according to any preceding claim wherein the beam is directed through the substrate to the interface and generates heat by interaction with the substrate.

6. A method according to any preceding claim wherein said beam is an infrared laser beam.

7. A method according to any preceding claim wherein said liquid phase is a solution comprising polymerisable monomers.

8. A method according to claim 7 wherein the solution contains a polymerisation initiator.

9. A method according to any preceding claim wherein said surface bears immobilised initiator molecules.

10. A method according to any preceding claim wherein said surface bears immmobilised polymerisable material.

11. A method according to any preceding claim wherein the scanning step employs a computer controlled movable mirror.

12. A method according to any preceding claim wherein after step (d), the liquid phase is replaced by a different liquid phase and steps (c) and (d) are repeated to deposit a second, different polymeric material.

13. A method according to any preceding claim wherein said liquid phase contains template molecules and, after step (d) template molecules are removed from the polymer to form imprinted cavities.

14. A process comprising fabricating a structure or pattern by a method according to any preceding claim and then using the fabricated structure or pattern in a process selected from high throughput screening assays for drug discovery, immunoassays, diagnostics, genetic analysis, or as a sensor component, lab-on-a-chip for performing chemical and/or biological experiments or as a research platform for studying and optimising separation, molecular recognition or catalytic processes.

## Patentansprüche

1. Verfahren zur Herstellung einer Struktur oder eines Musters, das ein Polymermaterial auf einem Substrat umfasst, umfassend: (a) das Bereitstellen eines Substrats; (b) das Bereitstellen einer ein polymerisierbares Material umfassenden flüssigen Phase in Kontakt mit einer Oberfläche des Substrats; (c) das Ausrichten eines Strahls, sodass er an der Grenzfläche zwischen Substrat und flüssiger Phase auf die Oberfläche auftritt, um eine örtlich begrenzte Erwärmung des Substrats auszulösen und nahe der bestrahlten Seite eine Polymerisation zu initiierten; und (d) das Abtasten mit dem Strahl in einem vorgegebenen Muster, wodurch eine Polymerisation mit einem entsprechenden Muster initiiert wird.

2. Verfahren nach Anspruch 1, wobei der Strahl ein sichtbarer Lichtstrahl, ein IR-, UV-, Röntgen-, Ionen-, Teilchen- oder Elektronenstrahl ist.

3. Verfahren nach Anspruch 2, wobei der Strahl ein Laserstrahl ist.

4. Verfahren nach einem der vorangegangenen Ansprüche, wobei der Strahl IR ist.

5. Verfahren nach einem der vorangegangenen Ansprüche, wobei der Strahl durch das Substrat auf die Grenzfläche gerichtet ist und durch Wechselwirkung mit dem Substrat Wärme erzeugt.

6. Verfahren nach einem der vorangegangenen Ansprüche, wobei der Strahl ein Infrarotlaserstrahl ist.

7. Verfahren nach einem der vorangegangenen Ansprüche, wobei die flüssige Phase eine Lösung ist, die polymerisierbare Monomere umfasst.

8. Verfahren nach Anspruch 7, wobei die Lösung einen Polymerisationsinitiator enthält.

9. Verfahren nach einem der vorangegangenen Ansprüche, wobei auf der Oberfläche immobilisierte Initiatormoleküle vorhanden sind.

10. Verfahren nach einem der vorangegangenen Ansprüche, wobei auf der Oberfläche immobilisiertes polymerisierbares Material vorhanden ist.

11. Verfahren nach einem der vorangegangenen Ansprüche, wobei beim Abtastschritt ein computergesteuerter beweglicher Spiegel eingesetzt wird.

12. Verfahren nach einem der vorangegangenen Ansprüche, wobei die flüssige Phase nach Schritt (d) durch eine andere flüssige Phase ersetzt wird und die Schritte (c) und (d) wiederholt werden, um ein zweites, anderes Polymermaterial aufzubringen.

13. Verfahren nach einem der vorangegangenen Ansprüche, wobei die flüssige Phase Matrizenmoleküle umfasst und nach Schritt (d) Matrizenmoleküle aus dem Polymer entfernt werden, um eingeprägte Vertiefungen zu erzeugen.

14. Verfahren, umfassend die Herstellung einer Struktur oder eines Musters durch ein Verfahren nach einem der vorangegangenen Ansprüche und anschließend die Verwendung der hergestellten Struktur oder des hergestellten Musters in einem Verfahren, das aus Hochdurchsatzscreeningtests zur Entdeckung von Arzneimitteln, Immuntests, diagnostischen Tests und genetischen Analysen ausgewählt ist, oder als Sensorkomponente, Lab-on-a-chip zur Durchführung von chemischen und/oder biologischen Versuchen oder als Forschungsplatte zur Untersuchung und Optimierung von Trennungs-, molekularen Erkennungs- oder Katalyseverfahren.

## Revendications

1. Procédé de fabrication d'une structure ou motif comprenant un matériau polymère sur un substrat, comprenant (a) la réalisation d'un substrat; (b) la réalisation d'une phase liquide comprenant un matériau polymérisable en contact avec une surface dudit substrat; (c) diriger un faisceau de rayonnement pour qu'il soit incident sur ladite surface à l'interface de substrat/phase liquide de manière à provoquer un échauffement localisé du substrat et à initier ainsi la polymérisation d'une manière adjacente au site irradié; et (b) amener le faisceau à balayer selon un motif prédéterminé, en initiant ainsi la polymérisation selon un motif correspondant.

2. Procédé selon la revendication 1, dans lequel ledit faisceau est un faisceau de lumière visible, IR, UV, rayons-X, ions, particules ou électrons.

3. Procédé selon la revendication 2, dans lequel le faisceau est un faisceau laser.

4. Procédé selon l'une quelconque des revendications précédentes, dans lequel le faisceau est IR.

5. Procédé selon l'une quelconque des revendications précédentes, dans lequel le faisceau est dirigé à travers le substrat sur l'interface et produit de la chaleur par l'interaction avec le substrat.

6. Procédé selon l'une quelconque des revendications précédentes, où ledit faisceau est un faisceau laser infrarouge.

7. Procédé selon l'une quelconque des revendications précédentes, dans lequel ladite phase liquide est une solution comprenant des monomères polymérisables.

8. Procédé selon la revendication 7, dans lequel la solution contient un initiateur de polymérisation.

9. Procédé selon l'une quelconque des revendications précédentes, dans lequel ladite surface supporte des molécules initiateurs immobilisés.

10. Procédé selon l'une quelconque des revendications précédentes, dans lequel ladite surface supporte un matériau polymérisable immobilisé.

11. Procédé selon l'une quelconque des revendications précédentes, dans lequel l'étape de balayage utilise un miroir mobile commandé par ordinateur.

12. Procédé selon l'une quelconque des revendications précédentes, dans lequel après l'étape (d), la phase liquide est remplacée par une phase liquide différente, et les étapes (c) et (d) sont répétées pour déposer un deuxième matériau polymère différent.

13. Procédé selon l'une quelconque des revendications précédentes, dans lequel ladite phase liquide contient des molécules gabarit et, après l'étape (d), les molécules gabarit sont retirées du polymère pour former des cavités imprimées.

14. Processus comprenant la fabrication d'une structure ou d'un motif par un procédé selon l'une quelconque des revendications précédentes, et ensuite l'utilisation de la structure ou motif fabriqué dans un processus sélectionné parmi des essais biologiques préliminaires à haut débit pour la découverte de médicaments, d'immunoessais, diagnostics, analyse génétique ou comme composant de détection, laboratoire sur puce pour exécuter des expériences chimiques et/ou biologiques ou comme une plate-forme de recherche pour étudier et optimiser des processus de séparation, de reconnaissance moléculaire ou catalytiques.
